Europäisches Patentamt

European Patent Office

Office européen des brevets

(11) Veröffentlichungsnummer: **0 168 584**
**B1**

# EUROPÄISCHE PATENTSCHRIFT

(45) Veröffentlichungstag der Patentschrift:
12.10.88

(51) Int. Cl.⁴: **G 01 R 25/00,** H 04 L 7/02,
H 03 K 5/26

(21) Anmeldenummer: 85105912.1

(22) Anmeldetag: 14.05.85

(54) Phasensynchronismus-Detektor.

(30) Priorität: 22.06.84 DE 3423102

(43) Veröffentlichungstag der Anmeldung:
22.01.86 Patentblatt 86/4

(45) Bekanntmachung des Hinweises auf die Patenterteilung:
12.10.88 Patentblatt 88/41

(84) Benannte Vertragsstaaten:
FR GB IT

(56) Entgegenhaltungen:
DE-A-3 245 438

PATENTS ABSTRACTS OF JAPAN, vol. 5, no. 198 (E-87) 870 , 16. Dezember 1981; & JP - A - 56 122 521 (TOKYO SHIBAURA DENKI K.K.) 26-09-1981

(73) Patentinhaber: ANT Nachrichtentechnik GmbH,
Gerberstrasse 33, D-7150 Backnang (DE)

(72) Erfinder: Annecke, Karl Heinz, Dr., Nansenstrasse
25/2, D-7150 Backnang (DE)
Erfinder: Hegny, Helmut, Dipl.- Ing., Stuttgarter
Strasse 89, D-7150 Backnang (DE)

(74) Vertreter: Wiechmann, Manfred, Dipl.- Ing., ANT
Nachrichtentechnik GmbH Gerberstrasse 33
Postfach 11 20, D-7150 Backnang (DE)

## Beschreibung

Die Erfindung betrifft eine Schaltungsanordnung zum Detektieren einer Phasensynchronität zweier verschiedener Taktsignale gemäß Oberbegriff Anspruch 1. Eine solche Schaltungsanordnung findet Anwendung auf den verschiedensten Gebieten der elektrischen Nachrichtenübertragung bzw. -verarbeitung, beispielsweise bei der Übergabe von Informationen zwischen zwei Systemen mit plesiochronen Takten oder bei einer Empfangsschaltung zur Synchronisation des Multiplexübertragungsrahmens.

Durch die US-Patentschrift US-A-3 328 688 ist ein Phasenkomparator mit bistabilen und logischen Elementen bekanntgeworden, wobei die beiden Eingangssignale jeweils auf den Signal- bzw. Takteingang zweier Flip-Flops gelegt sind. Die Schaltung vermag Phasendifferenzen zwischen $\pm$ 180° anzuzeigen.

Der Erfindung lag die Aufgabe zugrunde, eine Schaltung der eingangs genannten Art anzugeben, die mit hoher Sicherheit Flankensynchronismus zweier unterschiedlicher Taktsignale zu erkennen vermag und ein Alarm- oder Steuersignal daraus abzuleiten im Stande ist. Die Schaltungsanordnung soll so aufgebaut sein, daß sie wenig Aufwand erfordert. Die Lösung erfolgt mit den in dem Patentanspruch 1 gekennzeichneten Merkmalen. Die Schaltungsanordnung weist einen geringen Schaltungsaufwand auf und erfüllt die Voraussetzungen für Schaltungsintegration.

Es folgt die Beschreibung der Schaltungsanordnung anhand der Figuren. Die Figur 1 zeigt ein Ausführungsbeispiel der Schaltungsanordnung, die Figur 2 den zeitlichen Verlauf einiger Signale an wichtigen Punkten der Schaltungsanordnung und die Figur 3 schließlich ein weiteres Ausführungsbeispiel mit noch geringerem Schaltungsaufwand.

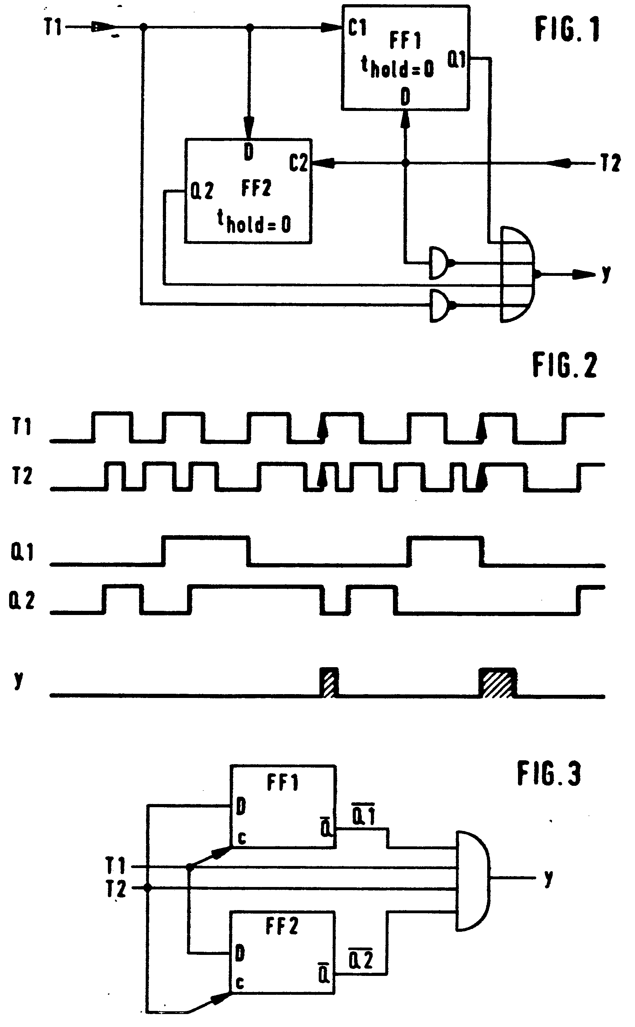

In Figur 1 sind zwei D-Flip-Flops FF1 und FF2 mit der Haltezeit $t_{Hold} = 0$ erkennbar, ihren Takteingängen wird jeweils einer der beiden Taktsignale T1 bzw. T2 und ihren D-Eingängen jeweils der andere Takt T2, T1 der beiden Taktsignale zugeführt. Die Ausgangssignale Q1, Q2 der D-Flip-Flops werden einem NOR-Glied zugeführt, dessen beiden andere Eingänge über zwei Inverter mit den beiden Taktsignalen T1 und T2 versorgt werden. Am Ausgang des NOR-Gliedes ist ein Ausgangssignal Y abgreifbar, das bei Eintritt des Flankensynchronismus der beiden Taktsignale T1 und T2 einem Impuls von der Länge des kürzeren Taktsignales abgibt.

In Figur 2 ist dies erkennbar, hier sind über der Zeit aufgetragen zuoberst die Taktsignale T1 und T2 mit unterschiedlichen Taktperioden und unterschiedlichem Phasenverlauf. Darunter sind die zeitlichen Verläufe der Ausgangssignale Q1 und Q2 der beiden D-Flip-Flops gezeichnet, und zuunterst ist das Ausgangssignal Y aufgetragen. Die Figur 3 zeigt ein noch aufwandgünstigeres Ausführungsbeispiel der erfindungsgemäßen Schaltungsanordnung, wobei außer den beiden D-Flip-Flops ein einziges UND-Glied mit vier Eingängen verwendet wird. Zwei dieser Eingänge werden mit den beiden Taktsignalen T1 und T2 beaufschlagt, während die beiden anderen Eingänge mit den invertierten Ausgangssignalen $\bar{Q}1$ und $\bar{Q}2$ der beiden D-Flip-Flops, welche eingangsseitig genauso wie in Figur 1 beschaltet sind, beaufschlagt werden. Am Ausgang des UND-Gliedes ist ebenfalls das Ausgangssignal Y abgreifbar. Der Vorteil der Anordnung nach Figur 3 liegt in der Anwendung bei höheren Taktfrequenzen, da die einzelnen Signalpfade annähernd die gleichen Verzögerungszeiten aufweisen. Ein weiterer Vorteil dieser Anordnung gegenüber derjenigen nach Figur 1 besteht darin, daß die Flankensynchronität um die längste Verzögerungszeit der Inverter früher angezeigt wird.

## Patentansprüche

1. Schaltungsanordnung zum Detektieren einer Phasensynchronität zweier verschiedener Taktsignale mittels zweier D-Flip-FLops, auf deren Signal- und Takteingänge jeweils die beiden Taktsignale geführt sind, dadurch gekennzeichnet, daß die beiden D-Flip-Flops eine Haltezeit ($t_{Hold}$) Null aufweisen, daß dem Takteingang des ersten D-Flip-Flops (FF1) der erste Takt (T1) und seinem D-Eingang der zweite Takt (T2) und dem Takteingang (C2) des zweiten D-Flip-Flops (FF2) der zweite Takt (T2) und seinem D-Eingang der erste Takt (T1) zugeführt wird, daß eine Logik vorgesehen ist, welcher als Eingangssignale die beiden Taktsignale (T1, T2) und die Ausgangssignale (Q1, Q2 oder $\bar{Q}1$, $\bar{Q}2$) der D-Flip-Flops (FF1, FF2) zugeführt werden und welche ein Ausgangssignal (Y) erzeugt nach der logischen Gleichung

$$\bar{Y} = Q1 + Q2 + \bar{T}1 + \bar{T}2 \text{ oder}$$

$$Y = \bar{Q}1 \cdot \bar{Q}2 \cdot T1 \cdot T2, \text{ und}$$

daß dieses Ausgangssignal (Y) dann einen Impuls aufweist, wenn die Flanken der beiden Taktsignale (T1, T2) zeitlich zusammenfallen.

2. Schaltungsanordnung nach Anspruch 1, dadurch gekennzeichnet, daß die Logik ein NOR-Glied mit vier Eingängen und zwei Inverter enthält, daß die Ausgänge (Q1, Q2) der beiden D-Flip-Flops (FF1, FF2) jeweils mit einem Eingang des NOR-Gliedes verbunden sind, daß dessen beiden anderen Eingängen jeweils über einen der Inverter die beiden Taktsignale (T1, T2) zugeführt sind und daß am Ausgang des NOR-Gliedes das Ausgangssignal (Y) abgreifbar ist (Fig. 1).

3. Schaltungsanordnung nach Anspruch 1, dadurch gekennzeichnet, daß die Logik ein UND-Glied mit vier Eingängen enthält,

daß zwei dieser vier Eingänge jeweils mit dem invertierten Ausgang ($\bar{Q}1$, $\bar{Q}2$) der D-Flip-Flops (FF1, FF2) verbunden sind und den anderen beiden Eingängen die Signale (T1, T2) zugeführt werden und

daß am Ausgang des UND-Gliedes das Ausgangssignal (Y) abgreifbar ist (Fig. 3).

### Claims

1. Circuit arrangement for the detection of a phase synchronism of two different timing signals by means of two D-flip-flops, to the signal and timing inputs of which both the timing signals are conducted each time, characterised thereby, that both the D-flip-flops display a holding time ($t_{Hold}$) of zero, that the first timing cadence (T1) is conducted to the pulse input of the first D-flip-flop (FF1) and the second timing cadence (T2) to its D-input and the second timing cadence (T2) is conducted to the pulse input (C2) of the second D-flip-flop (FF2) and the first timing cadence (T1) to its D-input, that a logic is provided, to which both the timing signals (T1, T2) and the output signals (Q1, Q2 or $\bar{Q}1$, $\bar{Q}2$) of the D-flip-flops (FF1, FF1) are conducted as input signals and which produces an output signal (Y) according to the logic equation

$$\bar{Y} = Q1 + Q2 + \bar{T}1 + \bar{T}2 \text{ or}$$

$$Y = \bar{Q}1 \cdot \bar{Q}2 \cdot T1 \cdot T2$$

and that this output signal (Y) displays a pulse when the flanks of the first timing cadence (T1) co-incide in time.

2. Circuit arrangement according to claim 1, characterised thereby, that the logic contains a NOR-member with four inputs and two inverters, the outputs (Q1, Q2) of both the D-flip-flops (FF1, FF2) are each connected with a respective input of the NOR-member, that both the timing signals (T1, T2) are conducted respectively by way of one of the inverters to both its other inputs and that the output signal (Y) is derivable at the output of the NOR-member (Fig. 1).

3. Circuit arrangement according to claim 1, characterised thereby, that the logic contains an AND-member with four inputs, that two of these four inputs are respectively connected with the output (Q1, Q2) of the D-flip-flops (FF1, FF2) and the signals (T1, T2) are conducted to both the other inputs and that the output signal (Y) is derivable at the output of the AND-member (Fig. 3).

### Revendications

1. Dispositif de circuit pour détecter un synchronisme de phase de deux signaux différents d'impulsion d'horloge au moyen de deux bascules électroniques à retard (bascule dont le signal de sortie est déterminé par le signal d'entrée apparu une impulsion d'horloge plus tôt), aux entrées de signal et d'impulsion d'horloge duquel on amène respectivement les deux signaux d'impulsion d'horloge, caractérisé en ce que les deux bascules électroniques à retard présentent un temps de maintien ($t_{Hold}$) nul;

en ce qu'à l'entrée d'impulsion d'horloge de la première bascule électronique à retard (FF1) on amène la première impulsion d'horloge (T1) et à son entrée D, la seconde impulsion d'horloge (T2); et ce qu'à l'entrée d'impulsion d'horloge (C2) de la seconde bascule électronique à retard (FF2), on amène la seconde impulsion d'horloge (T2), et à son entrée D, la première impulsion d'horloge (T1);

en ce qu'il est prévu un circuit logique auquel on amène, comme signaux d'entrée, les deux signaux d'impulsion d'horloge (T1, T2) et les signaux de sortie (Q1, Q2 ou $\bar{Q}1$, $\bar{Q}2$) des bascules électroniques à retard (FF1, FF2) et qui donne un signal de sortie (Y) selon l'équation logique

$$\bar{Y} = Q1 + Q2 + \bar{T}1 + \bar{T}2 \text{ ou}$$

$$Y = \bar{Q}1 \cdot \bar{Q}2 \cdot T1 \cdot T2; \text{ et}$$

en ce que signal de sortie (Y) présente alors une impulsion si les flancs des deux signaux d'impulsion d'horloge (T1, T2) coincident dans le temps.

2. Dispositif de circuit selon la revendication 1, caractérisé en ce que le signal logique contient un élément NON OU avec quatre entrées et deux inverseurs;

en ce que les sorties (Q1, Q2) des deux bascules électroniques à retard (FF1, FF2) sont respectivement reliées à une entrée de l'élément NON OU;

en ce qu'à ces deux autres entrées, on amène respectivement les deux signaux d'impulsion d'horloge (T1, T2) par l'intermédiaire de l'un des inverseurs; et

en ce qu'à la sortie de l'élément NON OU on peut prélever le signal de sortie (Y) (figure 1).

3. Dispositif de circuit selon la revendication 1, caractérisé en ce que le signal de logique contient un élément ET avec quatre entrées,

en ce que deux de ces quatre entrées sont respectivement reliées à la sortie soustractive ($\bar{Q}1$, $\bar{Q}2$) des bascules électroniques à retard (FF1, FF2); en ce qu'aux deux autres entrées on amène les signaux (T1, T2); et

en ce qu'à la sortie de l'élément ET on peut prélever le signal de sortie (Y) (figure 3).

0 168 584

FIG.1

FIG.2

FIG.3